# EUROPÄISCHE PATENTSCHRIFT

(11) **EP 2 430 490 B1**
(45) Veröffentlichungstag und Bekanntmachung des Hinweises auf die Patenterteilung: **07.03.2018**
(21) Anmeldenummer: 10718170.3
(22) Anmeldetag: 07.05.2010
(51) Int. Cl.: G02B 21/34, H01J 37/20, H01J 37/26

(54) **MIKROSKOPIE EINES OBJEKTES MIT EINER ABFOLGE VON OPTISCHER MIKROSKOPIE UND TEILCHENSTRAHLMIKROSKOPIE**
MICROSCOPY OF AN OBJECT USING A SEQUENCE OF OPTICAL MICROSCOPY AND PARTICLE BEAM MICROSCOPY
EXAMEN MICROSCOPIQUE D'UN OBJET PAR MICROSCOPIE OPTIQUE PUIS PAR MICROSCOPIE UTILISANT DES FAISCEAUX DE PARTICULES

(30) Priorität: 11.05.2009 DE 102009020663
(43) Veröffentlichungstag der Anmeldung: 21.03.2012
(73) Patentinhaber: Carl Zeiss Microscopy GmbH, 07745 Jena (DE)
(72) Erfinder: THOMAS, Christian, 73479 Ellwangen (DE); SIEVERS, Torsten, 89522 Heidenheim an der Brenz (DE); THESEN, Alexander, 73433 Aalen (DE)
(74) Vertreter: Patentanwälte Geyer, Fehners & Partner mbB
(86) Internationale Anmeldenummer: PCT/EP2010/056228
(87) Internationale Veröffentlichungsnummer: WO 2010/130639

(56) Entgegenhaltungen:
- EP-A2- 0 849 765
- EP-A2- 1 998 206
- WO-A1-99/53357
- WO-A1-03/003021
- DE-A1- 3 902 348
- US-A- 4 349 242
- US-A- 5 321 545
- US-A- 5 812 312
- US-A1- 2004 091 393

## Beschreibung

Die Erfindung bezieht sich auf das Mikroskopieren eines Objektes mit einer Kombination aus optischer Mikroskopie und Teilchenstrahlenmikroskopie und insbesondere auf ein Objektträger-System gemäß dem Oberbegriff des Anspruchs 1 und ein Mikroskopieverfahren gemäß dem Oberbegriff des Anspruchs 15..

Insbesondere für biologische und materialwissenschaftliche Proben ist oftmals eine Untersuchung sowohl mit optischer Mikroskopie, z.B. mit Lichtmikroskopie, und mit Teilchenstrahlenmikroskopie, z.B. Elektronenmikroskopie, wünschenswert. Im Stand der Technik verwendet man dazu aufwendige Mikroskope, die beide Mikroskopieverfahren durchführen können. Ein solches Mikroskop ist beispielsweise aus der EP 0849765 A2, der EP 1998206 A2 oder der US 6683316 B2 bekannt. Solche Kombinationsmikroskope sind insbesondere deshalb aufwendig, weil das optische Mikroskop vollständig in die Vakuumkammer, die für die Teilchenstrahlenmikroskopie benötigt wird, eingebaut werden muß, und ein Probentisch vorgesehen werden muß, der die Probe zwischen beiden Mikroskopen im Vakuum verschiebt. Die Folge sind ein relativ großes Vakuumvolumen und zudem ein hoher Aufwand bei der Fertigung des optischen Mikroskops, das dann in vakuumtauglicher Bauweise erstellt werden muß. Ein weiterer Nachteil ist es, daß eine optische Abbildung mit Immersion im Vakuum nicht realisiert werden kann. Verzichtet man bei der Teilchenstrahlmikroskopie auf Anordnung des Objektes im Vakuum, wie z. B. im Kombinationsmikroskop gemäß US 20080308731 A1, leidet die Abbildungsqualität, da die Elektronen an einer Membran sowie an Luft gestreut werden.

Eine Alternative für die Verwendung solcher Kombinationsmikroskope ist der sequentielle Einsatz von Einzelgeräten. Hierzu werden im Stand der Technik verschiedene Halterkonzepte verwendet. Für die optische Mikroskopie werden üblicherweise Objektträger aus Glas mit über die Probe gelegten Deckgläsern verwendet, die einige Zentimeter groß sind. In der Elektronikmikroskopie sind Netze üblich, die einige Millimeter groß sind, oder metallische Probenteller. Um nun ein zu mikroskopierendes Objekt, beispielsweise eine biologische Probe, von der optischen Mikroskopie zur Teilchenstrahlenmikroskopie zu verbringen, muß die Probe von einem Haltersystem auf das andere transferiert werden. Dies bringt einige Nachteile mit sich. Zum einen ist der Transfer zeitaufwendig und bringt die Gefahr der Probenbeschädigung oder Zerstörung mit sich. Zum anderen ist die Ortsreferenzierung in den beiden Mikroskopieverfahren schwierig, da die Position eines z. B. mit optischer Mikroskopie untersuchten Bereiches für die Teilchenstrahlenmikroskopie erst wieder gefunden werden muß. Auch die Verwendung von Markern im Objekt bzw. auf der biologischen Probe, hilft hier nicht weiter, da sich beim Transfer in der Regel auch die Probenstruktur, z.B. durch Verspannungen, ändert. Ein zeitaufwendiges und mühsames Wiederfinden der bereits zuvor mit dem anderen Verfahren mikroskopierten Objektstelle ist somit unvermeidbar.

Ein gattungsgemäßes Objektträger-System ist aus der US 5321545 A oder der US 2004/091393 A1 bekannt. Die DE 3902348 A1 schildert ein Objektträgerelement, auf das Objekte aufgelegt werden. Die Fläche, auf welche das Objekt aufgelegt wird, weist ein Punktmuster auf, das mittels Rasterelektronenmikroskopie und auch optisch detektierbar ist.Aus der US 4349242 A ist eine Klemmvorrichtung zum Befestigen einer Probe an einem Mikroskop bekannt. Die WO 03/003021 A1 beschreibt eine Vorrichtung zum Untersuchen biologischer Proben, die Justiermarkierungen aufweist.

Der Erfindung liegt die Aufgabe zugrunde, das Mikroskopieren eines Objektes mit einer Abfolge von optischer Mikroskopie und Teilchenstrahlenmikroskopie zu erleichtern, ohne den mit einem Kombinationsmikroskop erforderlichen Aufwand betreiben zu müssen.

Diese Aufgabe wird erfindungsgemäß durch ein Objektträger-System gemäß Anspruch 1 gelöst. Das System zum Mikroskopieren eines Objektes mit einer Abfolge von optischer Mikroskopie und Teilchenstrahlenmikroskopie weist auf: einen elektrisch leitfähigen Halter, wobei im Halter mindestens ein Fenster ausgebildet ist und wobei vorzugsweise der Halter die Abmessungen eines Standard-Glas-Objektträgers für die optische Mikroskopie hat, ein Objektträgerelement, das zum Tragen des zu mikroskopierenden Objektes ausgebildet ist und das über das Fenster legbar ausgebildet ist, und eine Befestigungseinrichtung, die zum Fixieren des Objektträgerelementes über dem Fenster ausgebildet ist.

Unter einem Fenster wird dabei in dieser Beschreibung auch eine Aussparung verstanden, die nicht komplett vom Material des Halters umschlossen ist, und z. B. am Rand des Objektträgers liegt.

Im Rahmen der Erfindung ist auch ein Verfahren zur Mikroskopie eines Objektes vorgesehen, bei dem das erfindungsgemäße Objektträger-System verwendet wird. Dabei wird das Objekt mit einem optischen Mikroskop und zuvor oder danach mit einem Teilchenstrahlmikroskop untersucht. Das Objekt wird also auf das Objektträgerelement aufgebracht und über das Fenster des Halters gelegt. Dann wird der Halter nacheinander in die beiden verwendeten Mikroskope, d. h. das optische Mikroskop und das Teilchenstrahlmikroskop eingesetzt, so daß das Objekt nacheinander mit beiden Mikroskopen untersucht wird.

Wie erwähnt, ist ein Umbetten des Objektes nicht möglich. Daß sich das Objekt in beiden Mikroskopen auf demselben Halter befindet, ist besonders dann vorteilhaft, wenn man zugleich Mikroskope verwendet, die eine Mechanik zum Bewegen des Halters aufweisen, wenn dieser in das Mikroskop eingelegt ist. Es wird im Verfahren ein Objektträger-System verwendet, dessen Halter die erwähnte(n) Justiermarkierung(en) aufweist. Es wird ein Objektbereich festgelegt, und bei der Mikroskopie mit dem zuerst verwendeten Mikroskop, z. B. dem optischen Mikroskop, wird eine Relativlage von Objektbereich und Justiermarke ermittelt, indem durch Betätigen der Mechanik sowohl der Objektbereich als auch die Justiermarke(n) mit dem zuerst verwendeten Mikroskop abgebildet werden. Da damit die Relativlage von Objektbereich und Justiermarke(n) bekannt ist, wird im anschließend verwendeten Mikroskop, z. B. dem Teilchenstrahlmikroskop, zuerst die Justiermarke abgebildet und aus der bereits bekannten Relativlage ausgehend von der Justiermarke der Objektbereich durch Betätigen der Mechanik angefahren.

Das Verfahren kann auch dahingehend ausgebildet werden, daß in beiden Mikroskopen die Lage der Justiermarke bezogen auf das jeweilige Mikroskop ermittelt wird, indem die Justiermarke(n) mit dem Mikroskop abgebildet wird (werden). Die Lagen von Objektbereichen werden dann in Bezug auf die Justiermarke(n) gespeichert.

Das Verfahren erlaubt es einfach, einen bestimmten Objektbereich in eine gewünschte Lage im jeweiligen Mikroskop zu bringen, das durch die Justiermarke(n) eine Kalibrierung des Objektbereiches bezogen auf die Lage zum Halter bewirkt wird.

Über die Justiermarkierung(en) kann die Mechanik zum Bewegen des Halters, beispielsweise ein Probentisch, sowohl im optischen Mikroskop als auch im Teilchenstrahlmikroskop hinsichtlich der Lage des Halters kalibriert werden. Dazu fährt man die Justiermarkierung(en) an, und die entsprechende Position der Mechanik, z. B. des Probentisches, wird ausgelesen. Das kann sowohl durch den Benutzer als auch automatisch unter Verwendung entsprechender Steuerungsmittel erfolgen. Durch die Justiermarkierung(en) ist zugleich eine Lageangabe für den Halter definiert; bei der Verwendung von drei Justiermarkierungen kann ein Koordinatensystem festgelegt werden. Somit kann die Stellung des Probenhalters für jeden interessierenden Objektbereich einfach bezogen auf die Justiermarkierung(en) abgespeichert werden. Nach dem Transfer des Halters in das zweite Mikroskop, z. B. das Teilchenstrahlmikroskop, erfolgt zunächst wieder die Kalibrierung über die Justiermarkierung(en), indem durch Betätigung der Mechanik, z. B. des Probenhalters, die Markierung(en) abgebildet wird/werden und dies mit der entsprechenden Stellung der Mechanik, z. B. des Probentisches, verknüpft wird. So können bereits abgespeicherte Objektbereiche einfach durch Betätigung der Mechanik angefahren werden. Der Benutzer muß sich nicht darum kümmern, zuvor definierte Objektbereiche im zweiten Mikroskop wieder neu zu finden.

Durch das erfindungsgemäße Objektträger-System kann das Objekt nacheinander mit getrennten Mikroskopen untersucht werden, ohne daß ein Transfer oder Umbetten des Objektes nötig wird. Die Erfindung schafft also ein korrelatives Objektträger-System, das es ermöglicht, die Probe auf einem Halter anzubringen und auf demselben Halter nacheinander sowohl mit einem optischen Mikroskop und einem Teilchenstrahlmikroskop zu untersuchen.

Unter dem Begriff optische Mikroskopie wird dabei im Sinne dieser Beschreibung jedes Mikroskopieverfahren verstanden, das zur Abbildung den optischen Gesetzen gehorchende Strahlung, insbesondere im sichtbaren Bereich, also Licht, verwendet. Teilchenstrahlenmikroskopie im Sinne dieser Beschreibung ist dann gegeben, wenn eine Abbildung mittels einem Strahl geladener Teilchen erfolgt, beispielsweise in Form der Elektronenstrahlmikroskopie. Soweit in dieser Beschreibung von Lichtmikroskopie oder Elektronenstrahlmikroskopie die Rede ist, ist dies lediglich beispielhaft für optische Mikroskopie bzw. Teilchenstrahlmikroskopie zu verstehen.

Der Halter des erfindungsgemäßen Objektträger-Systems ist sowohl für die optische Mikroskopie als auch für die Teilchenstrahlmikroskopie geeignet. Letzteres bedingt, daß er elektrisch leitfähig ist und vorzugsweise nicht oder nur in tolerierbaren, vorbestimmten Grenzen magnetisierbar. Die Probe, d.h. das zu mikroskopierende Objekt, wird auf dem Objektträgerelement gehalten bzw. getragen. Das Objektträgerelement kann dann über das im Halter ausgebildete Fenster gelegt werden, und die Befestigungseinrichtung fixiert das Objektträgerelement dann über dem Fenster. Durch diese Fixierung ist das Objekt auf dem Halter befestigt und kann sowohl mit optischer Mikroskopie als auch mit Teilchenstrahlmikroskopie untersucht werden, ohne daß ein Umbetten auf andere Träger erforderlich ist. Damit werden dieselben Vorteile erreicht, die ein Kombinationsmikroskop hat, ohne daß der mit einem solchen Kombinationsmikroskop verbundene Aufwand, das sowohl optische Mikroskopie als auch Teilchenstrahlenmikroskopie ausführen kann, betrieben werden muß. Auch ist die Abbildungsqualität sowohl im optischen als auch im Teilchenstrahlmikroskop sehr viel besser.

Durch das Fenster ist die Probe bzw. das Objekt, welches sich auf dem am Halter befestigten Objektträgerelement befindet, sowohl von oben, wie als auch von unten optisch zugänglich. Dies ermöglicht nicht nur Auflichtmikroskopie, sondern auch Durchlichtmikroskopie, soweit das Objektträgerelement entsprechend transparent ist. Analoges gilt für die Teilchenstrahlmikroskopie.

Um für die optische Mikroskopie einen möglichst geringen Arbeitsabstand zwischen Strahlengang des optischen Mikroskops und dem Objekt realisieren zu können, ist es vorteilhaft, das System so auszugestalten, daß die Probe sich möglichst nah an einer Seite, beispielsweise der Unterseite des Halters befindet. Dies kann auf einfache Weise dadurch erreicht werden, daß der Halter eine Vertiefung aufweist und das Fenster in der Vertiefung gebildet ist. Weiter ist das Objektträgerelement so in die Vertiefung einlegbar, daß sich die Probe bei über das Fenster gelegtem Objektträgerelement näher an einer Seite des Halters, beispielsweise der Unterseite, befindet, als an der anderen. Als Alternative zu einem eine Vertiefung aufweisenden Halter kann die Befestigungseinrichtung auch auf einer Seite, z. B. der Unterseite, des Halters angeordnet sein, so daß das Objektträgerelement an die entsprechende Seite des Halters und über das Fenster gelegt wird.

Auf das hier beschriebene Objektträger-System wird die Probe aufgebracht. Dann wird sie mit einem optischen Mikroskop und einem Teilchenstrahlenmikroskop untersucht, wobei die Reihenfolge applikationsabhängig gewählt werden kann. Der Halter wird in beide Mikroskope eingelegt. Üblicherweise untersucht man in einem Objekt bestimmte interessierende Objektbereiche. Um nach dem Einlegen bzw. Einbringen in das entsprechende Mikroskop die Lage des interessierenden Objektbereichs möglichst gut zu kennen bzw. eindeutig bestimmen zu können, ist auf dem Halter mindestens eine Justiermarkierung angebracht, die sowohl mit optischer Mikroskopie, als auch mit Teilchenstrahlmikroskopie detektierbar ist. Zusätzlich und optional kann der Halter mechanische Ausrichtmittel aufweisen, die zum Ausrichten des Halters in einem optischen Mikroskop und/oder einem Teilchenstrahlmikroskop ausgebildet sind. Diese mechanischen Ausrichtmittel können beispielsweise in Form eines Schlüssel/Schloß-Prinzipes, geeigneter Anschläge, Führungen, oder dergleichen gestaltet sein. Sie bewirken, daß der Halter in einer vorbestimmten Lage zum jeweiligen Mikroskop liegt, was innerhalb der Genauigkeit dieser Ausrichtung eine Referenzierung von Objektbereichen ermöglicht.

Die erfindungsgemäße Bauweise mit der mindestens einen Justiermarkierung leistet eine gesteigerte Genauigkeit. Sie ist besonders hoch, wenn mindestens drei Justiermarkierungen angebracht sind, die ein Koordinatensystem für den Halter festlegen. Dabei kann optional jede Justiermarkierung als Doppelmarkierung ausgeführt sein, die für zwei unterschiedliche Mikroskopie-Vergrößerungsstufen angepaßt sind.

Die Fixierung des Objektträgerelementes über dem Fenster trägt zur gewünschten Ortsfestigkeit des Objektes in beiden Mikroskopen bei. Diese Fixierung kann beispielsweise mittels einer Klemmeinrichtung realisiert werden. Es ist deshalb bevorzugt, daß die Befestigungseinrichtung mindestens eine neben dem Fenster mit dem Halter verbundene oder dort verankerte Klemmeinrichtung zum Fixieren des Objektträgerelementes über dem Fenster aufweist. Diese Klemmeinrichtung kann beispielsweise einen Klemmring und/oder Federringe umfassen.

Das Objektträgerelement trägt einerseits das Objekt bzw. die Probe und wird andererseits am Halter befestigt. Es kann je nach Mikroskop bzw. Objekt geeignet ausgestaltet sein. Insbesondere ist es möglich, das Objektträgerelement als leitfähiges Netz auszuführen. Die Befestigungseinrichtung ist dann so ausgebildet, daß sie das Netz über dem Fenster befestigt, beispielsweise festklemmt.

Eine alternative Realisierung für das Objektträgerelement ist ein Deckglas, wie es aus der Lichtmikroskopie bekannt ist. Ein solches Deckglas kann mit einer Befestigungseinrichtung kombiniert werden, die seitlich neben dem Fenster des Halters liegende Schienen aufweist, in die das Deckglas einschiebbar ist, so daß es auf diese Weise über das Fenster gelegt werden kann und zugleich am Halter befestigt ist. Gegebenenfalls weisen die Schienen zusätzlich geeignete Fixierungs- oder Klemmittel zum Fixieren des Deckglases in den Schienen auf.

In der optischen Mikroskopie wird zur Auflösungserhöhung häufig eine Immersionsflüssigkeit verwendet. Sie kann beispielsweise Öl oder Wasser beinhalten. Eine solche Flüssigkeit ist in der Teilchenstrahlmikroskopie in der Regel störend für das erforderliche Vakuum. Sie muß deshalb, möchte man die optische Mikroskopie vor der Teilchenstrahlmikroskopie ausführen, entfernt werden. Das ist besonders einfach möglich, wenn das System eine transparente Folie umfaßt, deren optische Brechzahl an die des Deckglases angepaßt ist und die das Deckglas vor einer für die optische Mikroskopie verwendeten Immersionsflüssigkeit schützt, so daß durch Abheben der Folie die Immersionsflüssigkeit entfernbar ist. Unter einem an den des Deckglases angepaßten Brechungsindex wird dabei insbesondere ein Brechungsindex verstanden, der dem des Deckglases möglichst (z. B. mit max. 10 % Abweichung) oder innerhalb vorgegebener Toleranzen (z. B. 0,1) gleicht. Weil herkömmliche Deckgläser eine Brechzahl von 1,5255 aufweisen, ist eine Folie besonders vorteilhaft, deren Brechzahl zwischen 1,4 und 1,6 liegt.

Zur Befestigung der Folie auf dem Deckglas kommen insbesondere elektrostatische Aufladungen, Adhäsion (Haftung durch lockere molekulare Bindungen, z. B. aufgrund von vander-Waals-Kräften) oder eine Klebeschicht in Frage. Damit letztere die Abbildung durch das optische Mikroskop nicht stört, beträgt die Dicke der Klebeschicht vorzugsweise nur ein Bruchteil (z. B. 1/10 oder weniger) der Wellenlänge der verwendeten Strahlung in der optischen Mikroskopie, oder die Brechzahl der Klebeschicht ist an die des Deckglases und der Folie innerhalb der genannten Toleranzen angepaßt bzw. angeglichen. Um keine Rückstände der Klebeschicht auf dem Deckglas zu erzeugen, ist die Klebeschicht vorzugsweise so ausgebildet, daß beim Entfernen der Folie ausschließlich die Klebeschicht an der Folie haften bleibt und nicht am Deckglas.

Zum einfacheren Abheben ist es möglich, die Folie mit einem Versteifungsring zu versehen, der am Rand der Folie umläuft. Er kann für eine topfartige Struktur der Folie mit Versteifungsring sorgen. Dadurch ist zum einen das Immersionsöl auf der Folie (z. B. in dieser topfartigen Struktur) sicher aufgenommen, zum anderen ist das Abheben der Folie erleichtert.

Ein Abheben der Folie ist auch dann einfach, wenn die Folie größer als das Fenster ist, da sie dann über den Fensterrahmen vorsteht und einfach abgenommen werden kann.

Alternativ zu einer Folie kann auch ein Ring verwendet werden, der an einer Unterseite eine Gummilippe aufweist, wobei das Ringinnere kleiner als das Deckglas ist, so daß der Ring auf das Deckglas legbar ist und mit der Gummilippe für die optische Mikroskopie auf das Deckglas aufgebrachte Immersionsflüssigkeit vom Deckglas abziehbar ist. Für eine derartige Ausgestaltung des Systems ist der Halter so geformt, daß das Deckglas an einem Rand nicht vom Halter so begrenzt wird, daß das Abziehen der Gummilippe behindert wäre. Vielmehr erlaubt der Halter es, bei im Halter befestigten Deckglas den Gummiring bzw. die Gummilippe über einen Rand des Deckglases hin abzuziehen.

Zur Befestigung des Halters im Mikroskop, insbesondere im Teilchenstrahlmikroskop ist ein Adapter vorteilhaft, der eine Montageeinrichtung zum Befestigen des Adapters an einer Aufnahmevorrichtung des Teilchenstrahlmikroskops aufweist und an dem eine Auflagefläche mit Halteeinrichtung zum Fixieren des Halters auf der Auflagefläche ausgebildet ist. Vorzugsweise weist dieser Adapter unter der Auflagefläche und über der Montageeinrichtung eine Aussparung zum Einführen eines Teilchenstrahldetektors auf, da dann eine Messung im Transmissionsbetrieb möglich ist.

Es versteht sich, daß die vorstehend genannten und die nachstehend noch zu erläuternden Merkmale nicht nur in den angegebenen Kombinationen, sondern auch in anderen Kombinationen oder in Alleinstellung einsetzbar sind, ohne den Rahmen der vorliegenden Erfindung zu verlassen.

Nachfolgend wird die Erfindung beispielsweise anhand der beigefügten Zeichnungen, die auch erfindungswesentliche Merkmale offenbaren, noch näher erläutert. Es zeigen:
- Fig. 1: eine perspektivische Darstellung einer ersten Ausführungsform eines Objektträger-Systems,
- Fig. 2: eine Schnittdarstellung entlang der Linie A-A der Fig. 1,
- Fig. 3: eine perspektivische Darstellung einer zweiten Ausführungsform eines Objektträger-Systems,
- Fig. 4: eine Schnittdarstellung entlang der Linie A-A der Fig. 3,
- Fig.5a-c: Schnittdarstellungen (Fig. 5a und b) bzw. eine Draufsicht (Fig. 5c) auf ein Objektträger-System ähnlich dem der Fig. 1,
- Fig. 6a-c: Schnittdarstellungen (Fig. 6a und b) bzw. eine Draufsicht (Fig. 6c) eines Objektträger-Systems ähnlich dem der Fig. 3,
- Fig. 7a-c: eine Schnittdarstellung (Fig. 7a) bzw. Draufsichten (Fig. 7b und c) des Objektträger-Systems der Fig. 5 erweitert um ein Bauteil zum Entfernen von Immersionsflüssigkeit vom Objektträger,
- Fig. 8a und 8b: Schnittdarstellungen einer alternativen Erweiterung des Objektträgers der Fig. 5, ebenfalls zur Entfernung von Immersionsflüssigkeit,
- Fig. 9: Draufsichten auf zwei Objektträgerbauweisen zur Verdeutlichung von Markierungen, die in der Mikroskopie ausgewertet werden, und
- Fig. 10 und 11: Schemadarstellungen eines Adapters zur Anbringung eines der Objektträger gemäß Fig. 1 bis 9 in einem Elektronenstrahlmikroskop.

Anhand der Figuren wird ein Objektträger-System beschrieben, mittels dem ein Objekt mit einer Kombination aus optischer Mikroskopie und Teilchenstrahlenmikroskopie untersucht werden kann. In der nachfolgenden Beschreibung wird als Beispiel für optische Mikroskopie die Lichtmikroskopie, und insbesondere auch die Fluoreszenzmikroskopie beschrieben. Dies ist natürlich nicht als Einschränkung zu verstehen, sondern soll lediglich der besseren Verständlichkeit dienen. Gleichermaßen wird als Beispiel für die Teilchenstrahlmikroskopie das Mikroskopieren mit Elektronenstrahlen geschildert, was ebenfalls nicht als Einschränkung für das beschriebene Objektträgersystem aufzufassen ist. Werden in den Beschreibungen Begriffe wie "Unterseite", "Oberseite", "links" und "rechts" verwendet, sind diese, soweit nicht anders beschrieben, auf die in den Figuren dargestellte Lage der Bauteile bezogen.

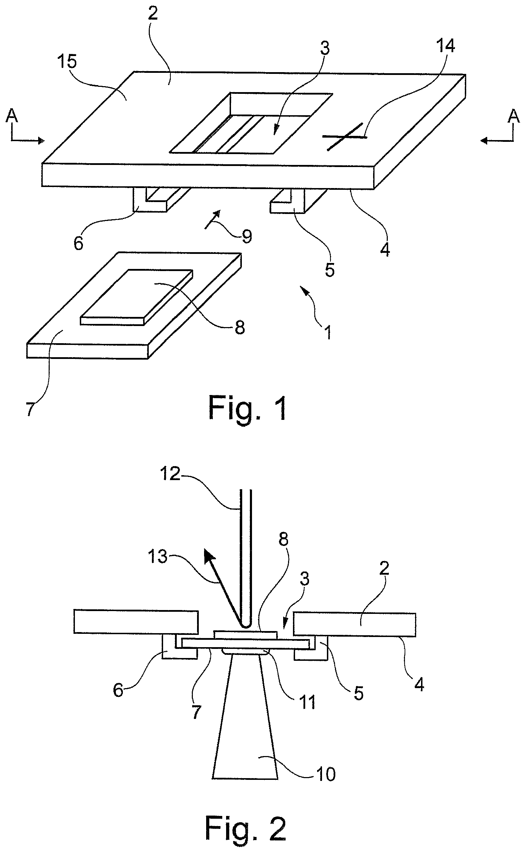

Fig. 1 zeigt ein Objektträger-System 1, mit dem ein Objekt, im beschriebenen Beispiel eine biologische Probe, mit einer Kombination aus Lichtmikroskopie und Elektronenstrahlmikroskopie untersucht werden kann. Das System 1 umfaßt einen metallischen Halter 2, der die Außenabmessungen eines Standardglasobjektträgers hat. Er ist also beispielsweise 75,5 mm lang und 25,5 mm breit. Eine solche Größe erlaubt eine besonders einfache Verwendung des Halters 2 in einem herkömmlichen Lichtmikroskop. Gegebenenfalls sind natürlich auch andere Größen für den Halter 2 möglich und je nach Anwendung vorteilhaft.

Der Halter 2 weist in einem zentralen Bereich, in dem üblicherweise die Lichtmikroskopie bei einem Glas-Objektträger zur Anwendung käme, ein Fenster 3 auf, das als vollständiger Durchbruch durch den plattenförmigen Halter 2 gebildet ist. An der Unterseite des Halters 2 sind seitlich des Fensters 3 Schienen 5 und 6 gebildet, in die ein Deckglas 7 eingeschoben werden kann, auf dem sich eine zu mikroskopierende Probe 8 befindet. Das Einschieben erfolgt in Richtung eines schematisch dargestellten Pfeiles 9. Optional (und nicht in Fig. 1 zu sehen) sind an den Schienen 5 und 6 Anschläge vorgesehen, die das Einschieben des Deckglases 7 begrenzen. Zusätzlich können auch Klemm- und Fixierungsmechanismen vorgesehen sein, welche das eingeschobene Deckglas 7 fixieren.

Fig. 2 zeigt eine Schnittdarstellung durch das System 1 mit eingeschobenem Deckglas 7, wobei der Schnitt entlang der Linie A-A erfolgte. Elemente, Merkmale bzw. Bauteile des Systems 1, die anhand der Fig. 1 bereits erläutert wurden, sind in Fig. 2 mit den selben Bezugszeichen versehen und werden hier (wie in anderen Figuren auch) nicht nochmals erläutert.

Der Halter 2 paßt aufgrund der Bauweise in jedes gängige Lichtmikroskop und kann aufgrund seiner metallischen Eigenschaft und des Fensters auch problemlos in ein Elektronenmikroskop eingebracht werden. Das an der Unterseite gehalterte Deckglas 4, auf dem sich die Probe 8 befindet, kann nun mit einem Lichtmikroskopstrahlengang 10 optisch erfaßt werden. Dabei kann ein Immersionsöl 11 auf das Deckglas 7 an der der Probe 8 gegenüberliegenden Unterseite des Deckglases 7 aufgebracht werden, wenn dies für die Lichtmikroskopie erforderlich ist. Natürlich kann für die hier beschriebenen Ausführungsformen grundsätzlich statt Öl auch ein anderes (z.B. wäßriges) Immersionsmittel verwendet werden.

Weiter erlaubt die Anordnung des Deckglases 7 an der Unterseite 4 des Halters 2, daß sich ein Mikroskopobjektiv problemlos an das Deckglas 7 annähern kann, so daß der beispielsweise für invertierte Lichtmikroskope übliche Arbeitsabstand von etwa 200 µm problemlos realisiert werden kann. Die Schienen 5 und 6 sind dazu geeignet ausgebildet, daß die das Deckglas 7 haltenden Feinschenkel der Schienen nicht mit dem Mikroskopobjektiv in Kontakt kommen können.

Das Fenster 3 bewirkt, daß die Probe auch optisch von zwei Seiten zugänglich ist, so daß auch eine Durchlichtmikroskopie einfach realisiert werden kann.

Von der Oberseite ist die Probe weiter für einen Elektronenstrahl 12 zugänglich, so daß sie im selben Halter 2 nicht nur mit Lichtmikroskopie, sondern auch mit Elektronenstrahlmikroskopie untersucht werden kann. Von der Probe abgestrahlte Rückstreu- und/oder Sekundärelektronen 13 geben dann ein elektronenmikroskopisches Bild der Probe 8.

Für elektronenmikroskopische Untersuchungen im Hochvakuum kann weiter die Probe 8 auch gegebenenfalls vor der Elektronenmikroskopie elektrisch leitend beschichtet werden.

Wesentlich für die Erfindung ist, daß die Probe 8 während aller Vorgänge auf dem in den Halter 2 eingeschobenen Deckglas 7 verbleiben kann. Die Zuordnung der Probe 8 zum Halter 2 ist somit in allen Präparations- und Mikroskopieschritten fest gegeben. Der Halter 2 weist deshalb geeignete Markierungsmittel auf, beispielsweise eine Markierung 14 an der Oberseite 15 des Halters, wobei die Markierung 14 für Elektronenstrahlmikroskopie sichtbar ist. Gleichermaßen findet sich auf der Unterseite 4 des Halters eine zugeordnete weitere Markierung, die mit der Lichtmikroskopie erfaßt werden kann. Natürlich können auch mehrere Markierungen verwendet werden. Vorteilhafterweise ist die Markierung/sind die Markierungen so ausgestaltet, daß sie ein Koordinatensystem definieren, anhand dessen die zu untersuchenden Probenbereiche zwischen Lichtmikroskopie und Elektronenstrahlmikroskopie korreliert werden können. Aufgrund dieser Korrelationsmöglichkeiten erlaubt das Objektträger-System 1 eine korrelierte Mikroskopie der Probe 8. Alternativ kann die Markierung 14 auf ein transparentes Medium aufgebracht sein, welches in ein weiteres oder dasselbe Fenster eingebracht wird, so daß sie für die Lichtmikroskopie von beiden Seiten erfaßbar ist.

Für solche elektronenmikroskopischen Untersuchungen im Hochvakuum ist es weiter vorteilhaft, wenn das Deckglas elektrisch leitend beschichtet oder elektrisch leitend ausgebildet ist. Aufgrund der Verwendung der Lichtmikroskopie kann dabei entweder eine optisch transparente elektrisch leitende Beschichtung zum Einsatz kommen, oder die elektrisch leitende Beschichtung ist/wird nur auf der Seite des Deckglases 7 aufgebracht, von der der Elektronenstrahl 12 auf die Probe 8 fällt. In der Darstellung der Fig. 1 und 2 wäre dies die Oberseite des Deckglases 7.

Abwandlungen des Objektträger-Systems 1 der Fig. 1 und 2 sind natürlich möglich, so können beispielsweise nicht nur ein Deckglas 7 sondern auch mehrere Deckgläser parallel in einem Halter verwendet werden. Auch sind andere Befestigungsmöglichkeiten anstelle der Schienen 5 und 6 möglich; Beispiele hierfür werden noch erläutert.

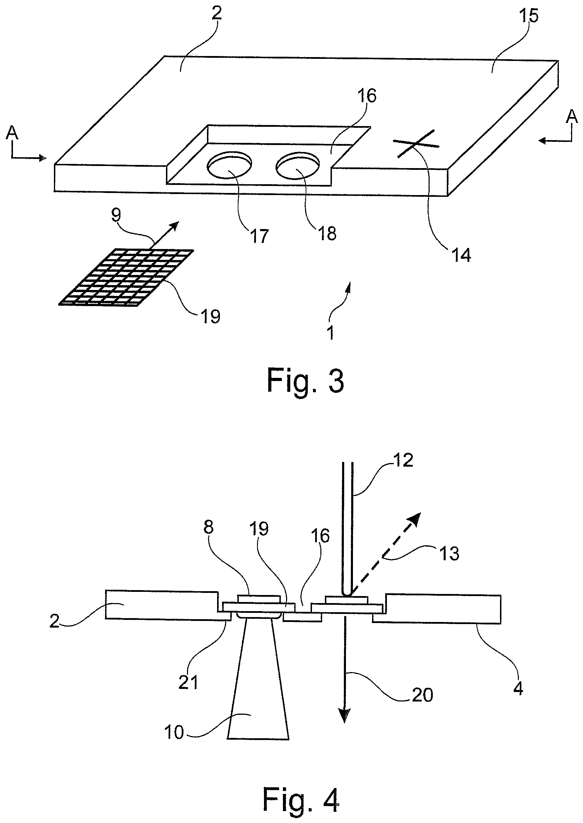

Fig. 3 zeigt eine weitere Bauweise des Objektträger-Systems 1. Der Halter 2 ist wiederum elektrisch leitend, beispielsweise aus Aluminium oder einem anderen leitenden Metall, gefertigt und weist wie bei der Bauweise der Fig. 1 und 2 auch die Abmessungen eines Standardobjektträgers für die Lichtmikroskopie auf. An der Oberseite des Halters 2 ist eine Vertiefung 16 gebildet, in der Fenster 17 und 18 liegen, welche als Durchgangslöcher durch den Halter 2 in der Vertiefung 16 ausgebildet sind. In diese Vertiefungen und über die Fenster 17, 18 sind Netze 19 legbar, die dann in Richtung des Pfeiles 9 in die Vertiefung 16 eingelegt werden. Die Netze 19 können mittels einer (in den Figuren nicht gezeigten) Klemmvorrichtung über den Fenstern 17 bzw. 18 festgeklemmt werden und sind dazu ausgebildet, auf ihrer Oberseite eine Probe 8 aufzunehmen.

Fig. 4 zeigt eine Schnittdarstellung entlang der Linie A-A des Objektträger-Systems 1 der Fig. 3, also eine Darstellung, die in ihrer Sicht der der Fig. 2 entspricht.

Wie zu sehen ist, ist die Probe 8 auf dem Netz 19 optisch sowohl von oben als auch von unten zugänglich, sie kann also mit einem Lichtmikroskopstrahlengang 10, der hier ohne Immersionsöl arbeitet, sowohl im Auflicht-, als auch im Durchlichtbetrieb mikroskopiert werden. Wie in der Bauweise der Fig. 1 auch, sind die Netze 19 so nahe wie möglich an der Unterseite 4 des Halters angeordnet, um eine Annäherung im Bereich des Arbeitsabstandes eines üblichen inversen Lichtmikroskopes zu ermöglichen. Dazu sind vorzugsweise die Stege 21, die nach Einbringung der Vertiefung 16 noch zwischen der Oberseite der Vertiefung 16 und der Unterseite 4 des Halters 2 verbleiben, mit einer Stegdicke von unter 200 µm, ausgearbeitet.

Für die Elektronenstrahlmikroskopie mittels des Elektronenstrahls 12 ist die Probe 8 nun ebenfalls von beiden Seiten zugänglich. Es ist also eine Elektronenstrahlmikroskopie mit Nachweis von Sekundär- und/oder Rückstreuelektronen 13, wie auch eine transmissive Elektronenstrahlenmikroskopie mit Nachweis von transmittierten Elektronen 20 möglich. Der Teilchenstrahl kommt z. B. von oben, und die Detektion kann ober- und unterhalb der Probe erfolgen.

Der Aufbau des Halters 2 erlaubt es weiter, den Elektronenstrahl auch seitlich auf die Probe 8 zu richten, um dreidimensionale Untersuchungen auszuführen.

Die Netze 19 sind vorzugsweise leitend ausgeführt, als Materialien kommen Kupfer, Gold, Nickel etc. in Frage.

Wesentlich für die Arbeitsweise des Objektträger-Systems ist es, daß die Probe auf dem Objektträgerelement (beispielsweise dem Deckglas 7 oder dem Netz 19) gegenüber dem Halter 2 ortsfest fixiert ist, so daß eine Verschiebung der Probe 8 relativ zum Halter 2 nicht auftritt.

Die anhand der Fig. 1 und 2 in dieser Hinsicht geschilderte Bauweise mit Schienen ist natürlich nicht die einzige Möglichkeit, das Objektträgerelement über dem Fenster 3 und bezüglich des Halters 2 zu fixieren.

Das Deckglas 7 ist ein Beispiel für ein Objektträgerelement, das zum Tragen des zu mikroskopierenden Objektes ausgebildet ist und das über das Fenster 3 gelegt werden kann.

Das Netz 19 der Bauweise der Fig. 3 ist also eine Alternative zum Deckglas 7 hinsichtlich der Realisierung des Objektträgerelementes.

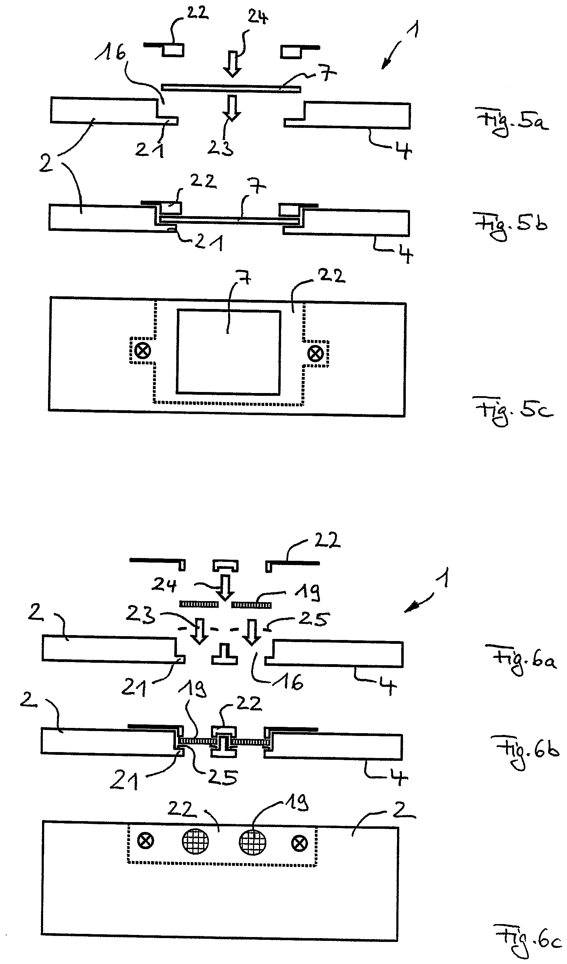

Die Fig. 5a-c zeigen eine diesbezügliche Abwandlung. Hier wird das Deckglas 7 in eine am Halter 2 ausgebildete Vertiefung eingelegt, die insofern der Vertiefung 16 der Bauweise der Fig. 3 entspricht und deshalb auch das selbe Bezugszeichen in Fig. 5a trägt. Die Fig. 5a und 5b zeigen Schnittdarstellungen eines Objektträger-Systems 1, das ebenfalls mit einem Deckglas 7 als Objektträgerelement arbeitet. Fig. 5a stellt den Vorgang des Zusammenbaus dar. In den Fig.5b und 5c ist als Schnittdarstellung bzw. Draufsicht der zusammengebaute Zustand dargestellt.

Das Deckglas 7 wird in die Vertiefung 16 in Richtung des Pfeiles 23 eingelegt. Über das Deckglas 7 wird ein Klemmring 22 in Richtung eines Pfeiles 24 eingelegt, der das Deckglas 7 zwischen einem an der Unterseite 4 des Halters 2 gebildeten Steg, der in seiner Funktion dem Steg 21 der Fig. 4 entspricht und deshalb auch in den Fig. 5a und b dieses Bezugszeichen trägt, und dem Klemmring 22 eingeklemmt. Der Klemmring 22 wird dabei, wie die Draufsicht der Fig. 5c zeigt, beispielsweise mittels Schrauben, die in den Halter 2 eingreifen, mit dem Halter 2 verschraubt.

Die Fig. 6a-6c zeigen eine Bauweise, die hinsichtlich der Befestigung des Objektträgerelementes der der Fig. 5a-c entspricht. Allerdings ist das System 1 der Fig. 6a-c für Netze 19 als Objektträgerelemente ausgebildet. Aufbau und Funktionsweise entsprechen im wesentlichen der Bauweise der Fig. 5a-c. Da die Netze 19 jedoch weniger starr sind, als das Deckglas 7, werden vor Einlegen der Netze 19 in die Vertiefung 16 Federringe 25 eingelegt, die die Netze 19 zusätzlich zwischen dem Klemmring 22 und dem Steg 21 einspannen und so für eine bessere Befestigung sorgen.

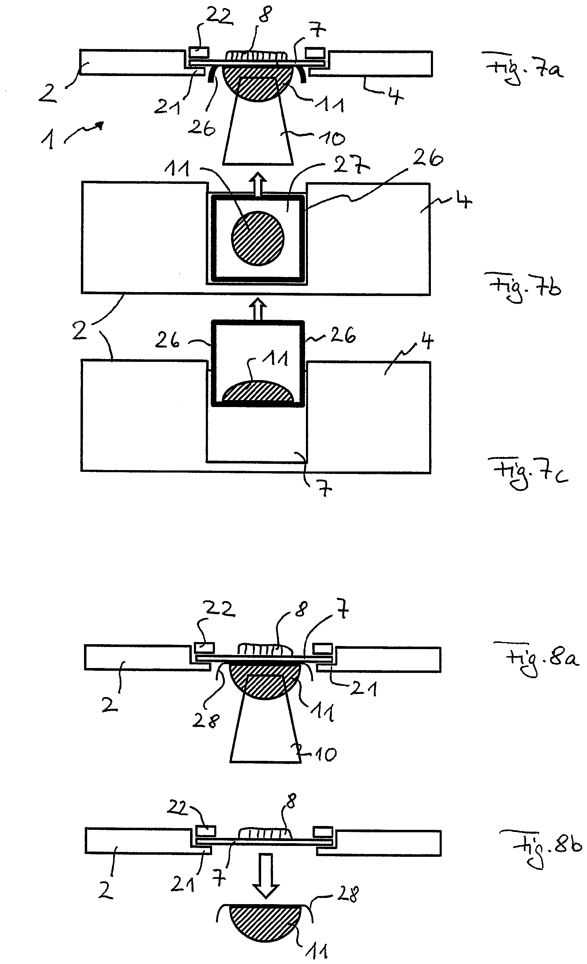

In der Lichtmikroskopie werden zur Auflösungserhöhung Immersionsmittel verwendet, beispielsweise Immersionsöle. Ein solches Immersionsöl ist beispielsweise mit dem Bezugszeichen 11 in Fig. 2 versehen. Da Elektronenstrahlenmikroskopie üblicherweise im Vakuum durchgeführt wird, muß Immersionsöl zuvor entfernt werden, wenn eine Probe zuerst mit Lichtmikroskopie und dann mit Elektronenstrahlmikroskopie untersucht werden soll. Die Fig. 7a bis 7c zeigen eine diesbezügliche Weiterbildung des Systems, welche eine Entfernung des Immersionsöls 11 oder eines anderen flüssigen Immersionsmittels einfach macht. Dazu ist an der Unterseite 4 des Halters 2 des Objektträger-Systems 1 auf das Deckglas 7, welches an der Oberseite die Probe 8 trägt, das Immersionsöl 11 aufgebracht, allerdings innerhalb eines Gummirings 26. Wie die Draufsicht der Fig. 7b, die von der Unterseite 4 auf den Halter 2 gerichtet ist, zeigt, ist das Immersionsöl 11 innerhalb der Öffnung 27 des Gummirings 26 angebracht. In dieser Ausgestaltung weist der Halter 2 weiter eine derartige Ausgestaltung auf, daß es möglich ist, den Gummiring 26 seitlich vom Deckglas 7 abzuziehen. In der Bauweise der Fig. 1 kann dies beispielsweise durch Verschieben des Gummirings 26 parallel zu den Schienen 5, 6 erfolgen. In der Bauweise mit Klemmring 22, wie sie in den Fig. 7a bis c gezeigt ist, hat der Halter 2 keinen an der Unterseite 4 umlaufenden Steg 21, sondern der Steg 21 läuft U-förmig um, so daß an einer Seite der Gummiring 26 vom Deckglas 7 abgezogen werden kann. Dadurch kann das Deckglas auf einfache Art und Weise von Immersionsflüssigkeit gereinigt werden, indem vor dem Einschleusen des Halters 2 in das Elektronenmikroskop der Gummiring über das Deckglas 7 abgezogen wird. Eine Kontamination des Vakuums des Elektronenmikroskops ist damit auf einfache Weise vermieden.

Die Fig. 8a und 8b zeigen eine alternative Ausgestaltung zur Verhinderung der Kontamination eines Elektronenmikroskops. Hierbei wird eine transparente Folie 28 verwendet, die zwischen das Immersionsöl 11 und das Deckglas 7 gelegt wird. Die Brechzahl von Kunststoffolien aus organischen Polymeren liegt in der Regel zwischen 1,3 und 1,7. So hat z.B. Polyethylenterephthalat (PET) eine Brechzahl von 1,5750, Polymethylmethacrylat (PMMA) von 1,4914 (für Plexiglas 7N), Polystyrol (PS) von 1,5900 (für PS 168 N), Polycarbonat(PC) von 1,5660 (für PC APEC 2097), Polymethylmethacrylimid (PMMI) von 1,5340 (für Pleximid 8817 F), oder cycloolefinische Copolymere (COC) haben eine Brechzahl von 1,5333 (für Topas 5013). Außerdem kann die Brechzahl von Polymerfolien durch Beigabe von anorganischen Nanopartikeln noch genauer angeglichen werden.

Die Folie 28 hat einen Brechungsindex, der an den des Deckglases 7 dahingehend angepaßt, ist, daß er dem des Deckglases 7 möglichst gleicht. Sie wird vor der lichtmikroskopischen Untersuchung so auf die der Probe 8 gegenüberliegende Unterseite des Deckglases 7 aufgebracht, daß kein Luftspalt oder Blasen entstehen, störende optische Eigenschaften wie Reflexion vermieden werden und die Folie 28 am Deckglas 7 haftet. Dies kann z.B. durch elektrostatische Aufladung oder Adhäsion geschehen oder durch eine dünne Klebeschicht, deren Dicke deutlich kleiner ist als die Wellenlänge des verwendeten Lichts oder deren Brechzahl an Deckglas 7 und Folie 28 angepaßt ist und die beim Entfernen der Folie 28 ausschließlich an dieser haften bleibt.

An Bereichen des Deckglases 7, wo keine lichtmikroskopische Untersuchung stattfindet, muß die Folie 28 nicht notwendigerweise eng am Deckglas 7 haften, sondern kann idealerweise auch abgehoben sein, um so ein Verlaufen des Immersionsöls 11, das zur lichtmikroskopischen Untersuchung aufgebracht wird, zu verhindern. Vor dem Einschleusen in das Elektronenmikroskop wird die Folie 28 mitsamt des Immersionsöls 11 abgezogen, und vom Halter 2 mit dem Deckglas 7 geht keine Kontaminationsgefahr für das Vakuumsystem des Elektronenmikroskops aus.

Natürlich kann die Folie 28 auch mit einem Versteifungsring versehen werden, der für eine topfartige Struktur der Folie 28 mit Versteifungsring sorgt, so daß das Immersionsöl 11 in dieser topfartigen Struktur sicher aufgenommen ist. Dies erleichtert das Abheben der Folie 28 mit dem Immersionsöl 11. Allerdings sollte die Versteifungsstruktur so ausgebildet sein, daß sie den Arbeitsabstand zwischen Lichtmikroskopstrahlengang 11, d.h. einem Objektiv des Lichtmikroskops, und der Unterseite des Deckglases 7 nicht beeinträchtigt.

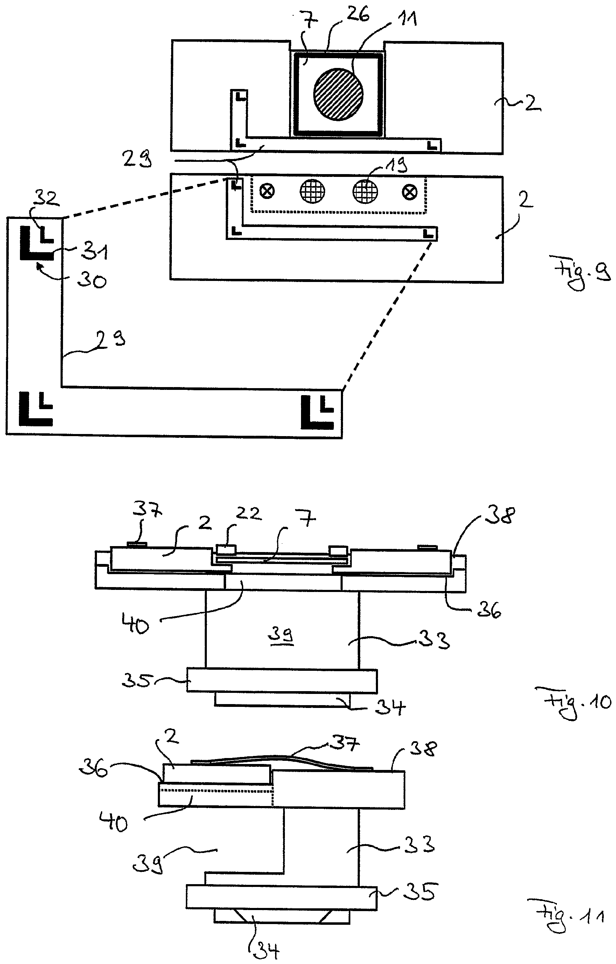

Die korrelative Mikroskopie durch eine Kombination aus Lichtmikroskopie und Elektronenstrahlenmikroskopie erreicht vorteilhaft, daß die Probe 8 relativ zum Halter 2 in allen Mikroskopiezuständen örtlich fixiert ist. Wie bereits erwähnt, kann zur Referenzierung dieser Lage am Halter 2 eine Markierung vorgesehen werden. Diese Ausgestaltung ist exemplarisch in Fig. 9 gezeigt, die sowohl eine Draufsicht auf den Halter 2 gemäß den Fig. 5a-c als auch auf den Halter gemäß Fig. 7a-c zeigt. Letzterer ist über dem Ersteren abgebildet. Um ein vom Mikroskop unabhängiges Koordinatensystem zu definieren, ist in diesem Ausführungsbeispiel auf dem Halter 2 eine Markierungsanordnung 29 vorgesehen, die ein Koordinatensystem für den Halter 2 festlegt. Die Markierungsanordnung besteht aus insgesamt drei Doppelmarkierungen 30, die beispielsweise, wie in Fig. 9 dargestellt, L-förmig zueinander liegen. Diese Anordnung ist in Fig. 9 als vergrößerte Teildarstellung eingetragen. Die L-förmige Ausbildung der Doppelmarkierungen 30 erlaubt eine eindeutige Festlegung des Koordinatensystems. Aus dem Abstand der Doppelmarkierungen 30 kann somit einfach Lage und Orientierung des Halters 2 ermittelt werden. Die Doppelmarkierungen 30 sind natürlich so ausgestaltet, daß sie sowohl mit der Lichtmikroskopie, als auch mit der Elektronenstrahlenmikroskopie detektierbar sind, z. B. als Chrom-Markierung auf transparentem und leitfähig beschichtetem Quarzglas.

Jede Doppelmarkierung 30 besteht aus zwei Einzelmarkierungen 31, 32 unterschiedlicher Größe, die somit für zwei verschiedene Vergrößerungsstufen geeignet sind.

Dies ist aber nicht zwingend so, alternativ können auch nur Einzelmarkierungen anstelle der Doppelmarkierungen 30 verwendet werden.

Wesentlich für die Markierungen ist, daß sie mit beiden Mikroskopieverfahren erfaßbar sind, oder daß Markierungen vorgesehen sind, die zueinander in bekannter Ausrichtung sind und jeweils für sich zumindest für eine der Mikroskopiemethoden wahrnehmbar ist.

Über die Markierungsanordnung 29 kann die Lage des Halters 2 sowohl in Lichtmikroskopie als auch in Elektronenstrahlmikroskopie kalibriert werden. Dazu werden nacheinander die drei Markierungen der Markierungsanordnung 29 angefahren und die entsprechende Position eines Verschiebetisches des Mikroskops ausgelesen. Dies kann sowohl manuell durch den Benutzer als auch automatisch unter Verwendung von Bildverarbeitungsalgorithmen erfolgen. Hat man derart die drei Markierungen der Markierungsanordnungen hinsichtlich ihrer Koordinaten bestimmt, ist das Koordinatensystem des Halters 2 definiert. Damit kann einfach die Position des Probentisches für jeden interessanten Probenbereich gespeichert werden. Nach dem Transfer des Halters 2 in das andere Mikroskop erfolgt zunächst wieder eine Kalibrierung der Lage der Markierungsanordnung 29. Anschließend können die zuvor abgespeicherten Probenbereiche dann automatisch und ohne zeitaufwendiges Suchen wieder angefahren werden.

Zur Befestigung des Halters 2 in einem Elektronenmikroskop ist vorzugsweise ein Adapter 33 vorgesehen, der in Fig. 10 und 11 dargestellt ist.

Dieser Adapter ermöglicht es, eine auf dem Halter 2 angeordnete Probe, die zuvor lichtmikroskopisch untersucht wurde, direkt in ein Elektronenmikroskop aufzunehmen und dort weiter zu analysieren. Der Adapter 33 weist dazu einen Schwalbenschwanz 34 auf, der an einem Fuß 35 zur Befestigung an einer Aufnahmevorrichtung des Elektronenstrahlmikroskops ausgebildet ist. Natürlich ist je nach Aufnahmevorrichtung des Elektronenstrahlmikroskops eine entsprechend passende Montageeinrichtung am Fuß 35 des Adapters 33 vorgesehen; der Schwalbenschwanz 34 ist hier nur exemplarisch dargestellt.

An der Oberseite des Adapters 33 befindet sich eine Auflage 38 zur Aufnahme des Halters 2. Dieser wird mit Klemmfedern 37 oder anderen geeigneten Halteeinrichtungen auf der Auflage 38 fixiert. In einer bevorzugten Ausgestaltung bewirkt der Adapter 33 zugleich auch noch eine Vorausrichtung des Halters 2, in dem er Mittel aufweist, die mit entsprechenden Gegenstücken am Halter 2 nach dem Schlüssel/Schloß-Prinzip zusammenwirken. Dieses Schlüssel/Schloß-Prinzip erreicht vorzugsweise eine vorjustierte Lage des Halters 2 mit einer Paßgenauigkeit von weniger als 50 µm. Beispielsweise kann der Adapter 33, wie in Fig. 10 und 11 gezeigt, an der Auflage 35 eine Aussparung 36 aufweisen, in welche am Halter 2 entsprechend vorgesehene Führungskanten eingreifen. Dadurch kann der Halter 2 in einer vorjustierten Stelle auf den Adapter 33 aufgelegt und dort mechanisch fixiert werden.

Um eine Transmissionsmessung in der Elektronenstrahlenmikroskopie zu ermöglichen, weist der Adapter 33 zwischen dem Fuß 35 bzw. dem Schwalbenschwanz 34 und der Auflage 38 eine Aussparung 39 und in der Auflage 38 eine Durchtrittsöffnung 40 auf, in die ein Transmissionselektronendetektor des Elektronenmikroskops eingeführt werden kann. Die Abmessungen des Adapters 33 wird so gestaltet, daß eine Probe, die sich auf dem eingesetzten Halter 2 befindet, welcher am Adapter 33 befestigt ist, sich im für das Elektronenmikroskop vorbestimmten Arbeitsabstand zum Polschuh befindet, beispielsweise in einem Abstand von 3 mm.

Für eine ordnungsgemäße Arbeitsweise ist der Adapter 33 weiter elektrisch leitend ausgebildet, um eine elektrostatische Aufladung des Adapters bzw. des Objektträgers 10 oder der Probe zu vermeiden und die Probe zu erden.

## Patentansprüche

1. Objektträger-System, wobei das System (1) aufweist:
- einen elektrisch leitfähigen Halter (2), wobei im Halter (2) mindestens ein Fenster (3; 17, 18) ausgebildet ist und wobei vorzugsweise der Halter (2) die Abmessungen eines Standard-Glas-Objektträgers für die optische Mikroskopie (10) hat,
- ein Objektträgerelement (7; 19), das zum Tragen eines zu mikroskopierenden Objektes (8) ausgebildet ist und das über das Fenster (3; 17, 18) legbar ausgebildet ist, und
- eine Befestigungseinrichtung (5, 6; 22, 25), die zum Fixieren des Objektträgerelementes (7; 19) über dem Fenster (3; 17, 18) ausgebildet ist,
**dadurch gekennzeichnet, dass**
- das Fenster (3; 17, 18) als vollständiger Durchbruch durch den Halter (2) ausgebildet ist,
- das Objektträger-System zum Mikroskopieren des Objektes (8) mit einer Abfolge aus optischer Mikroskopie (10) und Teilchenstrahlmikroskopie (12) ausgebildet ist,
- auf dem Halter (2) mindestens eine Justiermarkierung (14; 29) angebracht ist, die sowohl mit optischer Mikroskopie (10) als auch mit Teilchenstrahlmikroskopie (12) detektierbar ist, und
- die Befestigungseinrichtung (5, 6; 22, 25) das Objektträgerelement (7; 19) während der Abfolge aus optischer Mikroskopie (10) und Teilchenstrahlmikroskopie (12) fixiert.

2. System nach Anspruch 1, **dadurch gekennzeichnet, dass** der Halter (2) eine Vertiefung (16) aufweist, das Fenster (3; 17, 18) in der Vertiefung (16) gebildet ist und das Objektträgerelement (7; 19) in die Vertiefung (16) einlegbar ist, so dass das über das Fenster (3; 17, 18) gelegte Objektträgerelement (7; 19) sich näher an einer Unterseite (4) des Halters (2) als an einer Oberseite des Halters (2) befindet.

3. System nach Anspruch 1 oder 2, **dadurch gekennzeichnet, dass** auf dem Halter (2) mindestens drei Justiermarkierungen (30) angebracht sind, die ein Koordinatensystem für den Halter (2) festlegen.

4. System nach Anspruch 1, 2 oder 3, **dadurch gekennzeichnet, dass** jede Justiermarkierung (30) als Doppelmarkierung (31, 32) ausgeführt ist, die für zwei unterschiedliche Mikroskopie-Vergrößerungsstufen angepasst sind.

5. System nach einem der Ansprüche 1 bis 4, **dadurch gekennzeichnet, dass** das Objektträgerelement als Deckglas (7) ausgebildet ist.

6. System nach Anspruch 5, **dadurch gekennzeichnet, dass** die Befestigungseinrichtung seitlich neben dem Fenster (3) liegende Schienen (5, 6) aufweist, in die das Deckglas (7) einschiebbar und so über das Fenster (3) legbar ist.

7. System nach einem der Ansprüche 5 oder 6, **dadurch gekennzeichnet, dass** das System eine transparente Folie (28) umfasst, deren optische Brechzahl an die des Deckglases (7) angepasst ist und die das Deckglas (7) von der für die optische Mikroskopie (10) verwendeten Immersionsflüssigkeit (11) schützt, so dass durch Abheben der Folie (28) die Immersionsflüssigkeit (11) entfernbar ist.

8. System nach Anspruch 7, **dadurch gekennzeichnet, dass** die Folie (28) auf einer Seite eine Klebstoffschicht aufweist, die beim Abheben der Folie (28) vom Deckglas (7) ausschließlich an der Folie (28) haften bleibt.

9. System nach Anspruch 7 oder 8, **dadurch gekennzeichnet, dass** die Folie (28) größer als das Fenster (3) ist und/oder der Rand der Folie (28) mit einem Versteifungsring versehen ist.

10. System nach einem der Ansprüche 7 bis 9, **dadurch gekennzeichnet, dass** die Folie (28) eine Brechzahl hat, die von der des Deckglases (7) um maximal 10 % abweicht.

11. System nach einem der Ansprüche 5 oder 6, **dadurch gekennzeichnet, dass** das System (1) einen Ring (26) umfasst, der an einer Unterseite eine Gummilippe aufweist, wobei das Ringinnere (27) kleiner als das Deckglas (7) ist, so dass der Ring (26) auf das Deckglas (7) legbar ist und mit der Gummilippe für die optische Mikroskopie (10) auf das Deckglas (7) aufgebrachte Immersionsflüssigkeit (11) vom Deckglas (7) abziehbar ist.

12. System nach einem der obigen Ansprüche, **dadurch gekennzeichnet, dass** ein Adapter (33) vorgesehen ist, der eine Montageeinrichtung (34) zur Befestigung des Adapters (33) an einer Aufnahmevorrichtung eines Teilchenstrahlmikroskops aufweist und an dem eine Auflagefläche (35) mit Halteeinrichtung (36) zum Fixieren des Halters (2) auf der Auflagefläche (35) ausgebildet ist.

13. System nach Anspruch 12, **dadurch gekennzeichnet, dass** der Adapter (33) unter der Auflagefläche (35) und über der Montageeinrichtung (34) eine Aussparung (37) zum Einführen eines Teilchenstrahldetektors aufweist.

14. System nach einem der obigen Ansprüche, **dadurch gekennzeichnet, dass** der Halter (2) mechanische Ausrichtmittel aufweist, die zum Ausrichten des Halters (2) in einem optischen Mikroskop (10) und/oder einem Teilchenstrahlmikroskop (12) ausgebildet sind.

15. Verfahren zur Mikroskopie eines Objektes (8), wobei das Objekt (8) mit einem optischen Mikroskop (10) und zuvor oder danach mit einem Teilchenstrahlmikroskop (12) untersucht wird, **dadurch gekennzeichnet, dass** ein System (1) nach einem der Ansprüche 1 bis 14 verwendet wird, das Objekt (8) auf dem Halter (2) angeordnet und dieser nacheinander in beide Mikroskope (10, 12) eingelegt wird.

16. Verfahren nach Anspruch 15, **dadurch gekennzeichnet, dass** Mikroskope verwendet werden, die eine Mechanik zum Bewegen des Halters aufweisen.

17. Verfahren nach Anspruch 16, **dadurch gekennzeichnet, dass** ein Objektträger-System nach einem der Ansprüche 1 bis 3 verwendet wird, dass ein Objektbereich festgelegt wird, mit dem zuerst verwendeten Mikroskop die Relativlage von Objektbereich und Justiermarke ermittelt wird, indem durch Betätigen der Mechanik sowohl der Objektbereich als auch die Justiermarke mit dem zuerst verwendeten Mikroskop abgebildet werden, im anschließend verwendeten Mikroskop die Justiermarke abgebildet wird und ausgehend von der Justiermarke der Objektbereich durch Betätigen der Mechanik angefahren wird, wobei insbesondere in beiden Mikroskopen die Lage der Justiermarke bezogen auf das jeweilige Mikroskop ermittelt wird, und die Lagen von Objektbereichen in Bezug auf die Justiermarke gespeichert werden.

## Claims

1. Object carrier system, the system (1) comprising:
- an electrically conductive holder (2), at least one window (3; 17, 18) being formed in the holder (2) and, preferably, the holder (2) having the dimensions of a standard glass object carrier for optical microscopy (10),
- an object carrier element (7; 19) embodied to carry an object (8) to be examined under a microscope and embodied such that it is placeable over the window (3; 17, 18) and
- a fastening device (5, 6; 22, 25) embodied to fix the object carrier element (7; 19) over the window (3; 17, 18),
**characterized in that**
- the window (3; 17, 18) is embodied as a complete perforation through the holder (2),
- the object carrier system is embodied to examine the object (8) under a microscope in a sequence of optical microscopy (10) and particle beam microscopy (12),
- at least one adjustment mark (14; 29) is attached to the holder (2), said adjustment mark being detectable both by optical microscopy (10) and by particle beam microscopy (12), and
- the fastening device (5, 6; 22, 25) fixes the object carrier element (7; 19) during the sequence of optical microscopy (10) and particle beam microscopy (12).

2. System according to Claim 1, **characterized in that** the holder (2) has a depression (16), the window (3; 17, 18) is formed in the depression (16) and the object carrier element (7; 19) is insertable into the depression (16) such that the object carrier element (7; 19) placed over the window (3; 17, 18) is situated closer to a lower side (4) of the holder (2) than an upper side of the holder (2).

3. System according to Claim 1 or 2, **characterized in that** at least three adjustment marks (30) are attached to the holder (2), said adjustment marks setting a coordinate system for the holder (2).

4. System according to Claim 1, 2 or 3, **characterized in that** each adjustment mark (30) is embodied as a double mark (31, 32) adapted for two different microscopy magnification levels.

5. System according to one of Claims 1 to 4, **characterized in that** the object carrier element is embodied as a coverslip (7).

6. System according to Claim 5, **characterized in that** the fastening device has rails (5, 6) lying laterally next to the window (3), the coverslip (7) being insertable into said rails and thus being placeable over the window (3).

7. System according to either of Claims 5 and 6, **characterized in that** the system comprises a transparent film (28), the optical refractive index of which is adapted to that of the coverslip (7), said film protecting the coverslip (7) from the immersion liquid (11) used for the optical microscopy (10) such that the immersion liquid (11) is removable by lifting off the film (28).

8. System according to Claim 7, **characterized in that** the film (28) has an adhesive layer on one side, said adhesive layer only adhering to the film (28) when the film (28) is lifted off the coverslip (7).

9. System according to Claim 7 or 8, **characterized in that** the film (28) is larger than the window (3) and/or the edge of the film (28) is provided with a stiffening ring.

10. System according to one of Claims 7 to 9, **characterized in that** the film (28) has a refractive index which deviates by at most 10% from that of the coverslip (7).

11. System according to either of Claims 5 and 6, **characterized in that** the system (1) comprises a ring (26) having a rubber lip on a lower side, the ring interior (27) being smaller than the coverslip (7) such that the ring (26) is placeable onto the coverslip (7) and immersion liquid (11) applied onto the coverslip (7) for optical microscopy (10) may be pulled off the coverslip (7) with the rubber lip.

12. System according to one of the preceding claims, **characterized in that** provision is made of an adapter (33), said adapter comprising an assembly device (34) for fastening the adapter (33) to a recording device of a particle beam microscope and a placement surface (35) with a holding device (36) being formed on said adapter for fixing the holder (2) on the placement surface (35).

13. System according to Claim 12, **characterized in that** the adapter (33) has a cut-out (37) for introducing a particle beam detector below the placement surface (35) and above the assembly device (34).

14. System according to one of the preceding claims, **characterized in that** the holder (2) comprises mechanical alignment means embodied to align the holder (2) in an optical microscope (10) and/or in a particle beam microscope (12).

15. Method for examining an object (8) in a microscope, the object (8) being examined by an optical microscope (10) and, therebefore or thereafter, by a particle beam microscope (12), **characterized in that** a system (1) according to one of Claims 1 to 14 is used, the object (8) is arranged on the holder (2) and the latter is inserted successively into both microscopes (10, 12).

16. Method according to Claim 15, **characterized in that** use is made of microscopes which have a mechanism for moving the holder.

17. Method according to Claim 16, **characterized in that** use is made of an object carrier system according to one of Claims 1 to 3, **in that** an object region is set, the relative position of object region and adjustment mark being ascertained with the microscope used first by virtue of both the object region and the adjustment mark being imaged with the microscope used first by actuating the mechanism, the adjustment mark being imaged in the subsequently used microscope and, proceeding from the adjustment mark, the object region being approached by actuating the mechanism, the position of the adjustment mark in relation to the respective microscope being ascertained in both microscopes in particular, and the positions of object regions in relation to the adjustment mark being stored.

## Revendications

1. Système porte-objet, dans lequel le système (1) comprend :
- un support électriquement conducteur (2), dans lequel au moins une fenêtre (3 ; 17, 18) est ménagée dans le support (2) et dans lequel le support (2) présente de préférence les dimensions d'un porte-objet standard en verre destiné à la microscopie optique (10),
- un élément porte-objet (7 ; 19) qui est conçu pour porter un objet (8) à examiner au microscope et qui est conçu pour pouvoir être posé à travers la fenêtre (3; 17, 18), et
- un dispositif de fixation (5, 6 ; 22, 25) qui est conçu pour fixer l'élément porte-objet (7; 19) à travers la fenêtre (3 ; 17, 18),
**caractérisé en ce que**
- la fenêtre (3 ; 17, 18) est réalisée sous la forme d'une perforation complète à travers le support (2),
- le système porte-objet est conçu pour soumettre à un examen microscopique l'objet (8) conformément à une séquence de microscopie optique (10) et de microscopie par faisceau de particules (12),
- au moins un repère d'alignement (14; 29) est appliqué sur le support (2), lequel repère d'alignement peut être détecté tant par microscopie optique (10) que par microscopie par faisceau de particules (12), et
- le dispositif de fixation (5, 6; 22, 25) fixe l'élément porte-objet (7 ; 19) pendant la séquence de microscopie optique (10) et de microscopie par faisceau de particules (12).

2. Système selon la revendication 1, **caractérisé en ce que** le support (2) présente un creux (16), **en ce que** la fenêtre (3 ; 17, 18) est formée dans le creux (16) et **en ce que** l'élément porte-objet (7 ; 19) peut être mis en place dans le creux (16) de manière à ce que l'élément porte-objet (7 ; 19) mis en place à travers la fenêtre (3 ; 17, 18) se trouve plus près d'une face inférieure (4) du support (2) que d'une face supérieure du support (2).

3. Système selon la revendication 1 ou 2, **caractérisé en ce qu'**au moins trois repères d'alignement (30) sont appliqués sur le support (2), lesquels repères d'alignement définissent un système de coordonnées pour le support (2).

4. Système selon la revendication 1, 2 ou 3, **caractérisé en ce que** chaque repère d'alignement (30) est réalisé sous la forme d'un repère double (31, 32) qui est adapté à deux niveaux de grossissement de microscopie différents.

5. Système selon l'une quelconque des revendications 1 à 4, **caractérisé en ce que** l'élément porte-objet est réalisé sous la forme d'un verre couvre-objet (7).

6. Système selon la revendication 5, **caractérisé en ce que** le dispositif de fixation présente des rails (5, 6) situés latéralement sur le côté de la fenêtre (3), dans lesquels le verre couvre-objet (7) peut être amené à coulisser et peut être positionné à travers la fenêtre (3).

7. Système selon l'une quelconque des revendications 5 ou 6, **caractérisé en ce que** le système comprend une feuille transparente (28) dont l'indice de réfraction optique est adapté à celui du verre couvre-objet (7) et qui protège le verre couvre-objet (7) du liquide d'immersion (11) utilisé pour la microscopie optique (10), de manière à ce que le liquide d'immersion (11) puisse être éliminé par enlèvement de la feuille (28).

8. Système selon la revendication 7, **caractérisé en ce que** la feuille (28) présente sur une face une couche d'adhésif qui continue d'adhérer exclusivement à la feuille (28) lorsque la feuille (28) est séparée du verre couvre-objet (7).

9. Système selon la revendication 7 ou 8, **caractérisé en ce que** la feuille (28) est plus grande que la fenêtre (3) et/ou **en ce que** le bord de la feuille (28) est pourvu d'une bague de rigidité.

10. Système selon l'une quelconque des revendications 7 à 9, **caractérisé en ce que** la feuille (28) présente un indice de réfraction qui diffère d'au plus 10 % de celui du verre couvre-objet (7).

11. Système selon l'une quelconque des revendications 5 ou 6, **caractérisé en ce que** le système (1) comprend une bague (26) qui présente sur une face inférieure une lèvre en caoutchouc, dans lequel l'intérieur de la bague (27) est plus petit que le verre couvre-objet (7) de manière à ce que la bague (26) puisse être positionnée sur le verre couvre-objet (7) et à ce que le liquide d'immersion (11) appliqué sur le verre couvre-objet (7) puisse être retiré du verre couvre-objet (7) au moyen de la lèvre en caoutchouc pour la microscopie optique (10).

12. Système selon l'une quelconque des revendications précédentes, **caractérisé en ce qu'**il est prévu un adaptateur (33) comportant un dispositif de montage (34) pour la fixation de l'adaptateur (33) à un dispositif de réception d'un microscopie à faisceau de particules et sur lequel une surface d'appui (35) est réalisée de manière à comporter un dispositif de support (36) destiné à fixer le support (2) sur la surface d'appui (35).

13. Système selon la revendication 12, **caractérisé en ce que** l'adaptateur (33) comporte, en dessous de la surface d'appui (35) et sur le dispositif de montage (34), un évidement (37) destiné à insérer un détecteur de faisceau de particules.

14. Système selon l'une quelconque des revendications précédentes, **caractérisé en ce que** le support (2) comporte des moyens d'orientation mécaniques qui sont conçus pour orienter le support (2) dans un microscope optique (10) et/ou dans un microscope à faisceau de particules (12).

15. Procédé d'examen au microscope d'un objet (8), dans lequel l'objet (8) est examiné au moyen d'un microscope optique (10) et, à l'avance ou à la suite, au moyen d'un microscope à faisceau de particules (12), **caractérisé en ce qu'**un système (1) selon l'une quelconque des revendications 1 à 14 est utilisé, **en ce qu'**un objet (8) est disposé sur le support (2) et **en ce qu'**il est introduit dans les deux microscopes (10, 12) l'un après l'autre.

16. Procédé selon la revendication 15, **caractérisé en ce que** des microscopes qui comportent un mécanisme destiné à déplacer le support sont utilisés.

17. Procédé selon la revendication 16, **caractérisé en ce qu'**un système porte-objet selon l'une quelconque des revendications 1 à 3 est utilisé, **en ce qu'**une région d'un objet est déterminée, **en ce que** la position relative de la région de l'objet et de repères d'alignement est déterminée au moyen du microscope utilisé en premier lieu, une image de la région de l'objet et des repères d'alignement étant formée par le microscope utilisé en premier lieu par actionnement du mécanisme, **en ce qu'**une image du repère d'alignement est formée dans le microscope utilisé ensuite et **en ce qu'**à partir du repère d'alignement, la région de l'objet est déplacée par actionnement du mécanisme, dans lequel la position du repère d'alignement par rapport au microscope respectif est déterminée, notamment dans les deux microscopes, et les positions des régions de l'objet par rapport au repère d'alignement sont stockées.
